# EUROPÄISCHE PATENTSCHRIFT

(11) **EP 1 269 813 B1**
(45) Veröffentlichungstag und Bekanntmachung des Hinweises auf die Patenterteilung: **30.05.2007**
(21) Anmeldenummer: 01916925.9
(22) Anmeldetag: 14.03.2001
(51) Int. Cl.: H05K 13/04

(54) **VERFAHREN UND VORRICHTUNG ZUM ÜBERPRÜFEN VON ELEKTRISCHEN BAUTEILEN IN EINER BESTÜCKVORRICHTUNG FÜR SUBSTRATE**
METHOD AND DEVICE FOR MONITORING ELECTRIC COMPONENTS IN A PICK-AND-PLACE DEVICE FOR SUBSTRATES
PROCEDE ET DISPOSITIF PERMETTANT DE SURVEILLER DES COMPOSANTS ELECTRIQUES DANS UN DISPOSITIF DE MISE EN PLACE DE COMPOSANTS POUR SUBSTRATS

(30) Priorität: 28.03.2000 DE 10015271
(43) Veröffentlichungstag der Anmeldung: 02.01.2003
(73) Patentinhaber: SIEMENS AKTIENGESELLSCHAFT, 80333 München (DE)
(72) Erfinder: BURGER, Stefan, 81379 München (DE); DÜBEL, Rainer, 85598 Baldham (DE)
(86) Internationale Anmeldenummer: PCT/DE2001/000964
(87) Internationale Veröffentlichungsnummer: WO 2001/074127

(56) Entgegenhaltungen:
- EP-A- 0 886 465
- WO-A-99/49713
- PATENT ABSTRACTS OF JAPAN vol. 1999, no. 11, 30. September 1999 (1999-09-30) & JP 11 154797 A (MATSUSHITA ELECTRIC IND CO LTD), 8. Juni 1999 (1999-06-08) in der Anmeldung erwähnt

## Beschreibung

Die Erfindung bezieht sich auf ein Verfahren und eine Vorrichtung zum Überprüfen von elektrischen Bauteilen in einer Bestückvorrichtung für Substrate,
wobei die Bauteile durch einen Bestückkopf der Bestückvorrichtung gehandhabt werden, der in einer Arbeitsebene verfahren wird,
wobei ein Greifer für die Bauteile im Bestückkopf senkrecht zur Arbeitsebene mittels eines Hubantriebs zwischen einer Transportstellung und einer Funktionsstellung verschoben wird,
wobei das Bauteil gegen eine Unterseite des Greifers angesaugt wird,
wobei das Bauteil durch den Greifer aus einer Abholposition in die Transportstellung angehoben und nach dem Verfahren des Bestückkopfes in eine Bestückposition auf das Substrat in die Funktionsstellung abgesenkt wird und
wobei die Lagebeziehung zwischen dem Bauteil und dem Greifer durch eine optische Abtasteinrichtung des Bestückkopfes überprüft wird. Unter Lagebeziehung soll hier nicht nur die Relativlage der Bauteile am Greifer, sondern auch die Anwesenheit oder Abwesenheit des Bauteils am Greifer verstanden werden.

Eine derartige Vorrichtung ist durch die US 5 660 519 bekannt geworden. Danach besteht die Abtasteinrichtung des Bestückkopfes aus jeweils einer Reihe von Sende- und Empfangsdioden, die in der Höhe des in der Transportstellung befindlichen Bauteils eine zur Hubrichtung senkrechte Abtastebene bilden. Während der Bestückkopf zum Bestückort auf dem Substrat verfährt, können durch Verdrehen des Sauggreifers um die Hubachse die Seitenkonturen des Bauteils abgetastet werden, woraus sich die Lageabweichung der Bauteilemitte von der Greiferachse ermitteln läßt. Die Anwesenheit bzw. Abwesenheit des Bauteils am Greifer wird beim Abholen bzw. Aufsetzen des Bauteils durch Abtasten des Saugdrucks an der Pipette erkannt. Es versteht sich, dass auch beim optischen Vermessen die Anwesenheit bzw. Abwesenheit des Bauteils festgestellt werden kann.

Ferner ist durch die JP 11-154797 A eine Bestückvorrichtung mit einem feststehenden schrittweise umlaufenden Drehtisch bekannt, unter dem eine Leiterplatte in zwei Koordinatenrichtung verfahrbar ist. Der revolverartige Drehtisch ist mit einer Vielzahl von Greifern für die Bauelemente bestückt, die schrittweise verschiedene Stationen durchlaufen und die die Bauelemente von einer Abholposition zu einer gegenüberliegenden Aufsetzposition transportieren. Vor dem Abholen durchläuft das freie Greiferende eine Kontrollstation mit einer senkrechten Reihe von optischen Sende- und Empfangsdioden in der Art von Lichtschranken, wodurch die Höhenlage der Greiferunterseite ermittelt werden kann. Nach dem Abholen des Bauteils durchläuft das Greiferende mit dem Bauteil eine weitere optische Kontrollstation mit einer senkrechten Diodenreihe, wodurch die Höhenlage der Bauteilunterseite und somit dessen Bauhöhe ermittelt werden kann. Bei einem in zwei Koordinatenrichtungen verfahrbaren Bestückkopf müßte der Greifer vor und nach Abholen des Bauteils die ortfeste Kontrollstation durchlaufen, um eine entsprechende Messung durchführen zu können, was in aller Regel mit einem unakzeptablen Umweg zwischen der Abhol- und der und der Aufsetzposition und umgekehrt verbunden wäre.

Ferner ist es z.B. durch die US 4 875 285 bekannt, den Bestückkopf revolverartig mit einer Vielzahl von zirkulär an einem Rotor angeordneten Sauggreifern auszubilden, wobei ein Stator mit entlang der Umlaufbahn der Greifer angeordnete Bearbeitungsstationen für die Bauteile aufweist, die in diesen Stationen z.B. nach Spalte 2, Zeile 65 ff. zentriert, kontaktiert und elektrisch, optisch oder mechanisch vermessen werden. Es ist derzeit allgemein üblich die Lagebestimmung der Bauteile am Greifer mittels einer CCT-Kamera durchzuführen, die die Aufsetzseite der Bauteile, insbesondere die Lage der Kontaktflächen im Auflicht vermißt. Die Winkellage des Bauteils kann in einer nachfolgenden Drehstation korrigiert werden. Der x-y-Versatz wird durch eine entsprechende Korrektur der Zielkoordinaten des Bestückkopfes berücksichtigt.

Ferner ist durch die WO 9949713 A ein Revolverbestückkopf mit einem Stator und einem Rotor bekannt, der mit umlaufend angeordneten Greifern für die Bauelemente versehen ist. Ein Liniensensor ist am Stator außerhalb einer unteren Aufsetzstation zwischen zwei Haltestationen der Greifer in zur angeordnet und zur Drehachse des Rotors hin ausgerichtet. Die vorbeigleitenden, am Greifer haftenden Bauelemente können anhand der Abschattung des Sensors identifiziert werden. Da der Greifer in den Erfassungsbereich des Sensors bewegt werden muß, kann er nicht im unmittelbaren zeitlichen Zusammenhang mit dem Abholvorgang überprüft werden. Da das auf den Liniensensor gerichtete Licht nicht genau fokussiert werden kann, ist eine hinreichend scharfe Projektion insbesondere für stark miniaturisierte Bauelemente nicht möglich. Eine scharfe optische Fokussierung ist nur bei einem singulären Taststrahl z.B. einer Laser-Lichtschranke möglich.

Der derzeitige Trend zu immer kleineren Bauteilen von z.B. 0.25 mm Kantenlänge setzt einen sehr engen Saugkanal im Greifer voraus, der die Vakuumabfrage insbesondere bei Verschmutzung erschwert. Außerdem kann es durch Ungenauigkeiten der Abhollage dazu kommen, dass das Bauteil den Saugkanal nicht voll überdeckt und dass infolge dieser Leckage das Ergebnis der Vakuumabfrage unzuverlässig ist. Das Fehlen eines Bauteils wird so z.B. bei einem Revolverkopf u.U. erst in der Optikstation während der Bestückphase bemerkt. Das Abholen eines Ersatzbauteils erfordert einen erheblichen zusätzlichen Zeitaufwand.

Der Erfindung liegt die Aufgabe zugrunde, eine höhere Sicherheit bei der Überprüfung der Bauteile zu erreichen.

Diese Aufgabe wird durch die Erfindung gemäß Anspruch 1 gelöst. Beispielsweise kann der optisch präzise fokussierbare Taststrahl z.B. einer Laserdiode knapp unterhalb der Unterseite des Greifers im angehobenen Zustand angeordnet sein. Dadurch ist es möglich, vor dem Absenken des Greifers auf das abzuholende Bauteil die Unterseite des Greifers zu überprüfen. Im Normalfall wird der Strahlengang der Lichtschranke nicht unterbrochen sein. Daraufhin wird der Greifer auf das abzuholende Bauteil abgesenkt. Dieses wird nun angesaugt und angehoben. Unmittelbar darauf kann nun mit einem erneuten Tastimpuls sicher festgestellt werden, ob das Bauteil vom Greifer erfaßt wurde. Bei genauer Fokussierung des Taststrahls ist es möglich, den freien Abstand zwischen den Sende- und Empfangseinrichtungen besonders groß zu halten, so dass auch extrem große Bauteile hindurch geführt werden können und dass die Lichtschranke z.B. auch in einem Revolverbestückkopf eingesetzt werden kann, wo aufgrund der komplexen Bauweise eine enge Annäherung an das Bauelement nicht möglich ist.

Die Bauteile werden üblicherweise in Gurttaschen zugeführt. Beim Vorschieben des Gurtes kann es vorkommen, dass das Bauteil aufgrund von Erschütterungen aus der Tasche herausspringt oder seine Lage verändert, aber auch aufgrund der erwähnten Toleranzen kann es vorkommen, dass der Greifer das Bauteil nicht erfaßt. Durch die unmittelbar anschließende Abtastung kann sofort ein neuer Abholvorgang eingeleitet werden, bei dem der Gurt um eine weitere Taschenteilung nachgezogen wird, so dass der Greifer ein anderes Bauteil erfassen kann. Dies geschieht ohne weitere Verfahrbewegung des Bestückkopfes und somit mit geringem Zeitverzug.

Unmittelbar vor dem Aufsetzen des Bauteils auf das Substrat kann noch einmal eine Abtastung durchgeführt werden, um festzustellen, ob das Bauteil am Greifer noch vorhanden ist. Dies ist insofern vorteilhaft, als das Bauteil z.B. infolge von Erschütterungen, Beschleunigungen bzw. Verzögerungen des Bestückkopfes vor dem Aufsetzen verloren geht. In diesem Falle wird der Aufsatzhub des Greifers unterlassen. Dies ist insofern von Bedeutung, als sonst die Greiferunterseite auf die auf der Leiterplatte vorhandene Lotpaste aufsetzen würde, wodurch die Unterseite so stark kontaminiert wird, dass die Saugöffnung erheblich verengt oder gar verschlossen wird. Ist das Bauelement vorhanden, wird es auf das Substrat aufgesetzt und mittels eines Druckluftimpulses von der Unterseite abgelöst. Bei sehr kleinen Bauteilen kann jedoch die Klebewirkung einer kontaminierten Unterseite so groß sein, dass das Bauteil am Greifer haftet. Dies wird durch eine Abtastung unmittelbar nach dem Anheben des Greifers festgestellt, so dass der Greifer bevor der Bestückkopf die Aufsetzposition verläßt, noch einmal versuchen kann das Bauteil auf das Substrat aufzusetzen. Auf diese Weise wird ein hohes Maß an Abhol- und Bestücksicherheit erreicht.

Durch eine vorteilhafte Weiterbildung der Erfindung nach Anspruch 2 wird eine vollkommene Überwachung der Pipettenunterseite in allen Betriebsphasen erreicht.

Durch die Weiterbildung nach Anspruch 3 ist es möglich, nicht nur das Vorhandensein eines Bauteils zu überprüfen, sondern auch die Bauteilehöhe zu ermitteln, woraus sich zusätzliche Informationen über die Art des Bauteils gewinnen lassen. Beispielsweise kann es vorkommen, dass das in der Gurttasche einliegende Bauteil einseitig angesaugt wird, so dass es vom Greifer hochkant erfaßt wird. Mit Hilfe des genau fokussierten Taststrahls kann dies selbst bei den stark miniaturisierten besonders gefährdeten Bauelementen bereits beim Abholen als Abholfeder erkannt werden. Ein solches Bauteil wird in einer bestimmten Position abgeworfen und gelangt so nicht undefiniert auf das Substrat. Besonders vorteilhaft ist es, die Greiferspitze jeweils beim Hochfahren nach dem Aufsetzen ei nes Bauelements und nach dem Abholen des folgenden Bauelements zu vermessen, da die Hysterese des Wegmeßsystems bei gleicher Bewegungsrichtung entfällt.

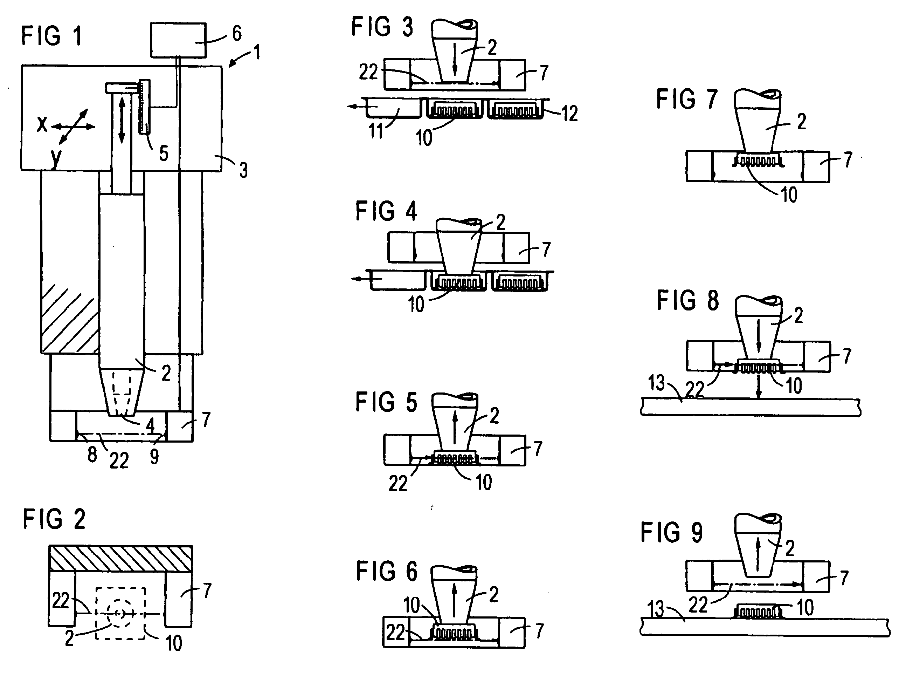

Die Vorrichtung nach Anspruch 4 löst in ähnlicher Weise wie das Verfahren nach Figur 1 die der Erfindung zugrundeliegende Aufgabe. Auch hier lassen sich die Verhältnisse an der Greiferunterseite vollständig überwachen, so dass die Bestücksicherheit entsprechend erhöht wird.

Die Vorrichtung nach Anspruch 5 ermöglicht ähnlich wie das Verfahren nach Anspruch 3 eine genauere Überprüfung der Bauteilehöhe in der Hubrichtung, woraus genauere Aufschlüsse über die Art oder die Einbaulage des Bauelements hergeleitet werden können.

Durch die Vorrichtung nach Anspruch 6 ist es möglich, die Abtasteinrichtung in einer Struktur zusammenzufassen, wodurch eine genaue geometrische Beziehung zwischen den Funktionsteilen hergestellt werden kann. Die Umlenkmittel nahe der Unterseite können z.B. durch ein Prisma gebildet werden, das den Taststrahl schräg nach oben zu einer Sendediode ablenkt.

Der Revolverbestückkopf nach Anspruch 7 weist z.B. 12 Sauggreifer auf, die sternförmig entlang einer zirkulären Umlaufbahn angeordnet sind. Der Rotor wird schrittweise angetrieben, so dass die Sauggreifer nacheinander in die Abholstation verdreht werden können, um in unmittelbarer Abfolge die Bauteile aufnehmen zu können. Dies bedeutet aber, dass die Bauteile bevor sie optisch inspiziert werden können, zumindest mehrere Stationen durchlaufen, bis sie zu einer Optikstation gelangen. In diesem Zeitraum ist es ohne die Abtasteinrichtung nach der Erfindung nicht möglich, die Bauteile optisch zu überprüfen. Ein Teil der Bauelemente wird erst in der Aufsatzphase an der Optikstation vorbeigeführt und überprüft. Abholfehler, die durch die Vakuumabfrage nicht erkannt werden können, werden dadurch erst in einer späteren Phase erkannt und sind so mit einem entsprechenden Zeitverlust verbunden. Durch die Erfindung ist es möglich, sämtliche Sauggreifer unmittelbar im Zusammenhang mit dem Abholvorgang zu überwachen, so dass im Falle eines Abholfehlers der Greifer einen neuen Abholversuch unternehmen kann, ohne dass der Rotor inzwischen weitergedreht werden kann. Es ist üblich, die optische Station zum Vermessen der Bauteillage mehrere Stationen vor der Aufsetzstation anzuordnen und den Greifer in einer nachfolgenden Station in die gewünschte Einbaulage zu drehen. Beim Verdrehen des Rotors und des Greifers kann es noch nach dem optischen Vermessen zum Bauteileverlust kommen, was ohne die Abtasteinrichtung in der Aufsetzstation nicht mehr erkannt werden könnte. Die optische Abtastung während des Aufsetzens erhöht daher die Uberwachungssicherheit im erheblichen Maße.

Durch die Weiterbildung nach Anspruch 8 ist es möglich, die Kabellichtschranke einstückig von der Statorseite her in den Verfahrweg der Bauteile eingreifen zu lassen.

Im folgenden Wird die Erfindung anhand von in der Zeichnung schematisiert dargestellten Ausführungsbeispielen näher erläutert.
- Figur 1: zeigt einen Schnitt durch einen Bestückkopf mit einem Sauggreifer und einer Steuereinrichtung,
- Figur 2: eine Draufsicht auf einen Teil des Bestückkopfes nach Figur 1,
- Figur 3: einen Teil des Bestückkopfes zu Beginn einer Abholphase mit einem Bauteilegurt und elektrischen Bauteilen,
- Figur 4: die Teile nach Figur 3 in einer nachfolgenden Phase,
- Figur 5: die Teile nach Figur 4 ohne den Bauteilegurt in einer anschließenden Phase,
- Figur 6: die Teile nach Figur 5 am Ende der Abholphase,
- Figur 7: die Teile nach Figur 6 nach dem Ende der Abholphase,
- Figur 8: die Teile nach Figur 7 während einer Aufsetzphase des Bauteils auf ein Substrat,
- Figur 9: die Teile nach Figur 9 nach dem Aufsetzen des Bauteils,
- Figur 10: eine Seitenansicht eines anderen, revolverartigen Bestückkopfes mit Bauteilen und einem Substrat,
- Figur 11: eine Seitenansicht der Teile nach Figur 10.

Nach Figur 1 ist ein in zwei Koordinatenrichtungen X und Y einer waagerechten Arbeitsebene X-Y verfahrbarer Bestückkopf 1 mit einem Greifer 2 versehen, der mittels seines Hubantriebs 3 senkrecht zur Arbeitsebene verschiebbar ist. Der Greifer 2 ist an seiner nach unten weisenden Spitze mit einer Saugöffnung 4 für zu greifende Werkstücke versehen. Der Hubantrieb 3 weist eine Wegmeßeinrichtung 5 auf, mit der die jeweilige Hubstellung des Greifers festgestellt werden kann und die über eine Datenleitung mit einer Steuereinrichtung 6 der Bestückvorrichtung verbunden ist. Im Bereich der Unterseite des Greifers 2 ist am Bestückkopf 1 eine Abtasteinrichtung 7 in Form einer Gabellichtschranke befestigt, die mit einer Sendediode 8 und einer Empfangsdiode 9 versehen ist. Die Dioden sind so angeordnet und aufeinander ausgerichtet, dass ein zwischen beiden verlaufender scharf gebündelter Taststrahl 22 die Greiferachse senkrecht kreuzt. Die Abtasteinrichtung 7 ist über eine weitere Datenleitung ebenfalls mit der Steuereinrichtung 6 verbunden.

In der gezeigten Transportstellung befindet sich der Greifer 2 in der obersten Hubstellung, bei der sich die Unterseite des Greifers 2 oberhalb der durch die Dioden definierten Abtasthöhe befindet. Die Steuereinrichtung 6 empfängt die Wegmeßwerte der Wegmeßeinrichtung 5. Die Abtasteinrichtung wird während der Absenk- und Hubphase des Greifers 2 aktiviert. Die von der Empfangsdiode empfangenen Signale werden ebenfalls der Steuereinrichtung 6 übermittelt. In dem Moment, in dem der empfangene Helligkeitswert der Empfangsdiode 9 einen Schwellenwert überschreitet, wird der gerade gemessene Hubweg des Greifers 2 zur weiteren Verwendung abgespeichert.

Figur 2 zeigt eine Draufsicht auf die Abtasteinrichtung 7, wobei die Position der Spitze des Greifers 2 und eines daran zu haltenden elektrischen Bauteiles 10 mit gestrichelten Linien angedeutet sind.

In den Figuren 3 bis 9 ist die Abfolge der Phasen eines Bestückzyklus in Bezug auf die Abtasteinrichtung 7 dargestellt.

Nach Figur 3 befindet sich der Bestückkopf mit seinem Greifer 2 über einem abzuholenden Bauteil 10 und ist aus seiner in Figur 1 dargestellten Ausgangslage bereits soweit abgesenkt, dass seine leere Unterseite den Taststrahl 22 der Abtasteinrichtung 7 kreuzt. Die entsprechende Greiferstellung wird durch die Steuereinrichtung abgespeichert. Es ist möglich eine solche Abtastung nach jedem Greiferwechsel durchzuführen und den so ermittelten Standardwert mit dem jeweiligen Meßwert beim Absenken des leeren Greifers zu vergleichen. Signifikante Abweichungen können dann auf einen Fehler an der Greiferspitze deuten, der z.B. auf Verunreinigungen oder ein anhaftendes Bauteil schließen läßt.

Nach Figur 4 setzt die Unterseite des Greifers 2 bereits auf das in einer Tasche 11 eines Gurtes 12 einliegende Bauteil auf und saugt dieses an.

Nach Figur 5 ist der Greifer 2 soweit angehoben, dass sich seine Unterseite oberhalb des Taststrahls 22 befindet und dass das angesaugte Bauteil 10 den Taststrahl 22 unterbricht. Bereits in diesem Moment kann anhand des abgespeicherten Wertes festgestellt werden, dass das zu erfassende Bauteil am Greifer 2 vorhanden ist.

Nach Figur 6 ist der Greifer 2 mit dem angesaugten Bauteil 10 gerade soweit angehoben, dass die Unterseite des Bauteils 10 den Taststrahl 22 freigibt. Diese Statusänderung wird von der Steuereinrichtung 6 (Figur 1) erkannt, mit dem zugehörigen Abtastwert der Wegmeßeinrichtung 5 abgespeichert. In diesem Moment kann bereits der früher abgespeicherte Wert mit dem aktuellen verglichen werden, wobei die Höhendifferenz in der Hubstellung ein Maß für die Höhe des Bauteils 10 darstellt. Sind die beiden Abtastwerte unverändert geblieben, so bedeutet dies, dass das Bauteil 10 nicht hinreichend angesaugt und angehoben wurde. Der Steuereinrichtung sind außerdem die Bauteiledaten aus einer Bauteilebibliothek bekannt. Eine Abweichung in den Höhenwerten kann bedeuten, dass ein falscher Bauteiletyp bereitgestellt worden ist oder dass das Bauteil in einer falschen Stellung angesaugt wurde. Solche Bauteile können über einer Abwurfstelle entfernt werden. Der Fehlversuch kann einen erneuten Abholvorgang auslösen, bevor der Greifer die Abholposition verläßt.

Nach Figur 7 ist der Greifer 2 in seine obere Transportstellung angehoben, in der sich das Bauteil 10 oberhalb der Tasthöhe befindet. Der Bestückkopf 1 kann nun in die Bestückstellung für das Bauteil 10 verfahren.

Nach Figur 8 befindet sich der Greifer 2 mit dem Bauteil 10 genau in dieser Bestückposition über einem Substrat 13 in der Absenkphase. Dabei kann entsprechend Figur 5 überprüft werden, ob das Bauteil 10 noch am Greifer vorhanden ist. Diese Überprüfung, die auch mit einer erneuten Höhenmessung verbunden sein kann, ermöglicht eine sichere Aussage über das Vorhandensein des Bauteils 10. Ist dieses auf dem Transport unterwegs verloren gegangen, so wird der Greifer 2 nicht weiter abgesenkt, so dass seine Spitze nicht mit auf dem Substrat 13 vorhandener Lotpaste kontaminiert werden kann.

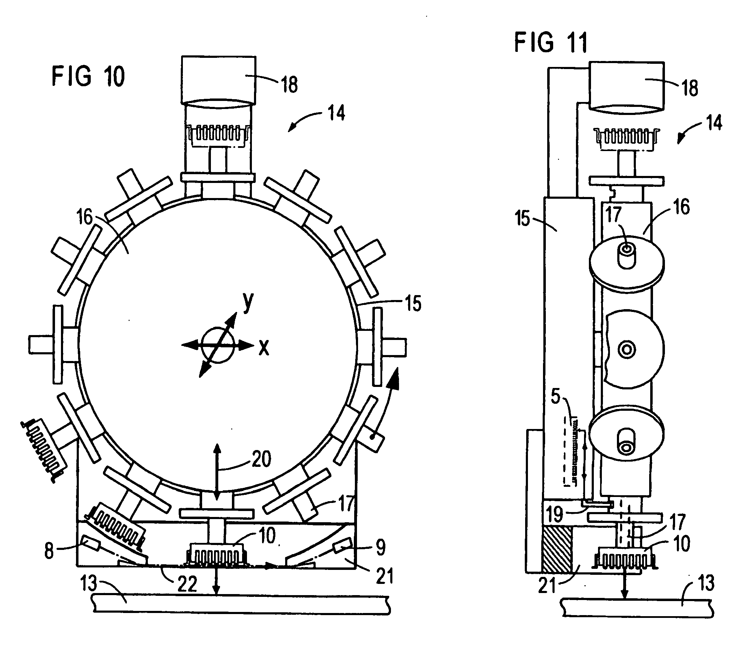

Nach Figur 9 ist das Bauteil 10 bereits auf das Substrat 13 aufgesetzt und die leere Unterseite des Greifers 2 ist über das Abtastniveau angehoben. Während dieses Vorganges wird der Status der Empfangsdiode 9 kontinuierlich überwacht, so dass festgestellt werden kann, ob sich das Bauteil tatsächlich vom Greifer 2 gelöst hat.

Nach den Figuren 9 und 10 ist ein anderer Bestückkopf 14 revolverartig ausgebildet und in der Arbeitsebene in beiden Koordinatenrichtungen x und y verfahrbar. Er weist einen Stator 15 auf, an dem ein Rotor 16 schrittweise drehbar gelagert ist. Am Rotor sind abgewandelte Greifer 17 sternförmig abstehend zirkulär umlaufend angeordnet. Während eines Abholzyklus können auf diese Weise sämtliche Greifer 17 der Reihe nach mit Bauelementen belegt werden, bevor der Bestückkopf über das Substrat 13 verfährt. Entlang der Umlaufbahn der Greifer 17 befindet sich eine Abtastoptik 18, mit der die Unterseite der Bauteile 10 genau vermessen werden kann. Das bedeutet, dass ohne eine Abtasteinrichtung das Vorhandensein und der Typ des Bauteils 10 erst in dieser Phase sicher überprüft werden können. Eine Fehlaufnahme könnte somit erst bei einem nächsten Abholzyklus korrigiert werden.

Ein anderer Hubantrieb 19 mit der Wegmeßeinrichtung 5 ist einer Hubstation 20 zugeordnet und befindet sich mit dem zugehörigen Greifer 17 in temporärem Eingriff. Eine andere Abtasteinrichtung 21 ist am Stator 15 derart befestigt, dass der Taststrahl 22 knapp oberhalb tangential zur Umlaufbahn der Bauteile 10 gerichtet ist. Durch diese Anordnung ist es möglich, die Abtasteinrichtung ebenfalls als Gabellichtschranke mit einem einstückigen bügelartigen Träger auszubilden, dessen Basis auf einer Seite der Umlaufbahn am Stator 15 befestigt ist. Auch bei diesem Bestückkopf 14 können den Figuren 3 bis 9 entsprechende Abtastschritte durchgeführt werden.

## Patentansprüche

1. Verfahren zum überprüfen von elektrischen Bauteilen (10) in einer Bestückvorrichtung für Substrate (13),
wobei die Bauteile (10) durch einen Bestückkopf (1) der Bestückvorrichtung gehandhabt werden, der in einer Arbeitsebene (x-y) verfahren wird,
wobei ein Greifer (2) für die Bauteile (10) im Bestückkopf (1) senkrecht zur Arbeitsebene (x-y) mittels eines Hubantriebs (3) zwischen einer Transportstellung und einer Funktionsstellung verschoben wird,
wobei das Bauteil (10) gegen eine Unterseite des Greifers (2) angesaugt wird,
wobei das Bauteil (10) durch den Greifer (2) aus einer Abholposition in die Transportstellung angehoben und nach dem Verfahren des Bestückkopfes (1) in eine Bestückposition auf das Substrat (13) in die Funktionsstellung abgesenkt wird,
wobei die Lagebeziehung zwischen dem Bauteil (10) und dem Greifer (2) durch eine optische Abtasteinrichtung (7) des Bestückkopfes (1) überprüft wird,
wobei das Bauteil (10) durch die Hubbewegung des Greifers (2) in den Wirkbereich zumindest eines quer zur Hubrichtung orientierten Taststrahls (22) der Abtasteinrichtung (7) gelangt,
wobei sich die Unterseite des Greifers (2) in der Transportstellung oberhalb des Taststrahls (22) befindet,
**dadurch gekennzeichnet,**
**dass** der Bestückkopf (1) eine Steuereinrichtung (6)aufweist, die die Hubstellung des Greifers (2) so kontrolliert und
**dass** die Abtasteinrichtung (7) mit der Steuereinrichtung (6) derart gekoppelt wird,
**dass** die Abtasteinrichtung (7) in einer Phase vor und einer Phase nach dem Ansaugen des Bauteils (10) aktiviert wird,
**dass** die Steuereinrichtung (6) die Anwesenheit bzw. Abwesenheit des Bauteils (10) am Greifer (2) aus den Abtastwerten der Abtasteinrichtung (7) erkennt,
und **dass** die Steuereinrichtung (6) zwischen den beiden Phasen gleichbleibende Abtastwerte als Betriebsfehler bewertet.

2. Verfahren nach Anspruch 1,
**dadurch gekennzeichnet,**
**dass** die Abtasteinrichtung (7) beim Abholen und beim Aufsetzen des Bauteils (10) aktiviert wird.

3. Verfahren nach Anspruch 1 oder 2,
**dadurch gekennzeichnet,**
**dass** die Unterseite des Bauteils (10) in der Transportstellung über das Höhenniveau des eng fokussierten Taststrahls (22) angehoben wird,
**dass** die Unterseite des Greifers (2) in dessen Funktionsstellung unter das Höhenniveau des Taststrahls (22) verschoben wird,
**dass** der Hubantrieb (3) eine Wegmeßeinrichtung (5) zur Bestimmung der Hubposition des Greifers (2) aufweist,
**dass** die Wegmeßeinrichtung (5) mit der Steuereinrichtung (6) gekoppelt ist,
**dass** die Hubeinrichtung während des Anhebens und/oder Absenkens des Bauteils (10) aktiviert wird und
**dass** die Steuereinrichtung (6) die Höhenlage der Unterseite des Bauteils (10) bzw. des Greifers (2) anhand der Änderungen der Abtastwerte beim Kreuzen der Unterseiten und anhand der jeweiligen Hubposition des Greifers (2) ermittelt.

4. Vorrichtung zum Überprüfen von elektrischen Bauteilen (10) in einer Bestückvorrichtung für Substrate (13),
wobei die Bestückvorrichtung einen in einer Arbeitsebene (x-y) verfahrbaren Bestückkopf (1) zum Handhaben der Bauteile (10) aufweist,
wobei ein Greifer (2) für die Bauteile (10) im Bestückkopf (1) senkrecht zur Arbeitsebene (x-y) mittels eines Hubantriebs (3) zwischen einer Transportstellung und einer Funktionsstellung verschiebbar gelagert ist,
wobei das Bauteil (10) gegen die Unterseite des Greifers (2) ansaugbar ist,
wobei das Bauteil (10) durch den Greifer (2) aus einer Abholposition in die Transportstellung anhebbar ist und nach dem Verfahren des Bestückkopfes (1) in eine Bestückposition auf das Substrat (13) in die Funktionsstellung absenkbar ist,
wobei der Bestückkopf (1) eine optische Abtasteinrichtung (7) zur Überprüfung des Bauteils (10) am Greifer (2) aufweist und
wobei die Abtasteinrichtung (7) zumindest einen quer zur Hubrichtung orientierten, in der Hubrichtung schmalen Taststrahl (22) empfängt,
wobei das Bauteil (10) durch die Hubbewegung des Greifers (2) in den Wirkbereich des Taststrahls (22) bringbar ist, und
wobei sich die Unterseite des Greifers (2) in der Transportstellung oberhalb des Taststrahls (22) befindet,
**dadurch gekennzeichnet,**
**dass** der Bestückkopf (1) eine Steuereinrichtung (6) zur Kontrolle der Hubbewegung des Greifers (2)aufweist,
**dass** die Abtasteinrichtung (7) mit der Steuereinrichtung (6) gekoppelt ist, wobei die Steuereinrichtung derart ausgebildet ist,
**dass** sie die Abtasteinrichtung (7) in einer Phase vor und einer Phase nach dem Ansaugen des Bauteils (10) aktiviert **dass** sie (6) die Anwesenheit bzw. Abwesenheit des Bauteils (10) am Greifer (2) aus den Abtastwerten des Abtasteinrichtung (7) erkennt,
und **dass** sie zwischen den beiden Phasen gleichbleibende Abtastwerte als Betriebsfehler bewertet.

5. Vorrichtung nach Anspruch 4,
**dadurch gekennzeichnet,**
**dass** der Taststrahl (22) in der Transportportstellung des Bauteils (10) unterhalb von dessen Unterseite angeordnet ist, **dass** die Unterseite des Greifers (2) in dessen Funktionsstellung sich unterhalb des scharf fokussierten Taststrahls (22) befindet
**dass** der Hubantrieb (3) eine Wegmeßeinrichtung (5) zur Bestimmung der Hubposition des Greifers (2) aufweist,
**dass** die Wegmeßeinrichtung (5) mit der Steuereinrichtung (6) gekoppelt ist,
**dass** die Hubeinrichtung während des Anhebens und/oder Absenkens des Bauteils (10) aktivierbar ist und
**dass** die Steuereinrichtung (6) die Höhenlage der Unterseite des Bauteils (10) bzw. des Greifers (2) anhand der Änderungen der Abtastwerte beim Kreuzen der Unterseiten und anhand der jeweiligen Hubposition des Greifers (2) ermitteln und daraus die Höhe des Bauteils (10) berechnen kann.

6. Vorrichtung nach Anspruch 5,
**dadurch gekennzeichnet,**
**dass** die Abtasteinrichtung (7) als Gabellichtschranke mit einem bügelförmigen Träger für die optischen Funktionsteile (z.B. 8, 9) ausgebildet ist und
**dass** der Taststrahl (22) durch Umlenkmittel nahe der dem Substrat (13) zugewandten Unterseite der Abtasteinrichtung (7) angeordnet ist.

7. Vorrichtung nach Anspruch 4, 5 oder 6,
**dadurch gekennzeichnet,**
**dass** der revolverartig ausgebildete Bestückkopf (14) einen Stator (15) aufweist, an dem ein Rotor (16) schrittweise drehbar gelagert ist,
**dass** der Rotor (16) mit einer Vielzahl der zirkulär verteilten Greifer (17) versehen ist,
**dass** der Greifer (17) durch den Hubantrieb (19) in einer Hubstation (20) des Bestückkopfes (14) absenkbar und anhebbar ist,
**dass** die am Stator (15) befestigte Abtasteinrichtung (21) der Hubstation (20) zugeordnet ist und
**dass** der Stator (15) des Bestückkopfes (1) außerhalb der Hubstation (20) zusätzlich zur Abtasteinrichtung (7) mit einer Optikstation (18) zur Lageermittlung des Bauteils (10) am Greifer (2) versehen ist.

8. Vorrichtung nach Anspruch 7,
**dadurch gekennzeichnet,**
**dass** der Taststrahl (22) in der Drehrichtung der Bauteile (10) orientiert ist.

## Claims

1. Ad hoc network as a connection between a local area network (1) with its services and at least one body-worn network (5), in which at least one computer (2.1) in the local area network detects the local services located in the local area network, translates them into Jini services (3.x) and offers them on the IP plane with the use of Jini middleware for body-worn networks (5), **characterized in that** appliances (5.x) that belong to the body-worn network (5) communicate with each other via a WLAN base station (6) of the local area network and are connected via the WLAN base station (6) to the local area network (1), and the services offered in the local area network (1) are assigned location-dependent attributes and one of the appliances (5.x) that belongs to the body-worn network is assigned the same location-dependent attribute as the WLAN base station (6) via which the connection to the body-worn network (5) is set up.

2. Ad hoc network according to the preceding Patent Claim 1, **characterized in that** the at least one computer (2.1), which translates the Jini services, serves as server in the local area network.

3. Ad hoc network according to the preceding Patent Claim 1, **characterized in that** the at least one computer, which translates the Jini services, serves as client of the local area network.

4. Ad hoc network according to the preceding Patent Claim 1, **characterized in that** the at least one computer (6), which translates the Jini services, serves as base station of a room network.

5. Ad hoc network according to one of the preceding Patent Claims 1 to 4, **characterized in that** the connection between the at least one computer, which translates the Jini services, and the body-worn network is set up in a wireless fashion and/or with galvanic coupling.

6. Ad hoc network according one of the preceding Patent Claims 1 to 5, **characterized in that** the location-dependent attributes are selected in a room-specific fashion.

7. Ad hoc network according to one of the preceding Patent Claims 1 to 6, **characterized in that** given the presence of a plurality of similar services (3.x) in the local area network are offered respectively the services nearest in location as a matter of priority or exclusively to each appliance (5.x) located in a body-worn network (5).

8. Ad hoc network according to one of the preceding Patent Claims 1 to 7, **characterized in that** the location-dependent attributes are defined hierarchically in accordance with their location-dependent possibility of use.

## Revendications

1. Réseau ad-hoc en tant que liaison entre un réseau (1) local avec ses services et au moins un réseau physique (5), dans lequel au moins un ordinateur (2.1) détecte dans le réseau local les services locaux se trouvant dans le réseau local, les convertit en services Jini (3.x) et les offre au niveau IP en utilisant du Middleware Jini pour des réseaux physiques (5), **caractérisé en ce que** des appareils (5.x) appartenant au réseau physique (5) communiquent entre eux au moins d'une station de base WLAN (6) du réseau local (1) et sont en liaison par la station de base WLAN (6) avec le réseau local (1) et des attributs dépendants du lieu sont attribués aux services offerts dans le réseau (1) local et à l'un des appareils (5.x) appartenant au réseau physique est attribué le même attribut dépendant du lieu qu'à la station de base WLAN (6), par laquelle la liaison est établie avec le réseau physique (5).

2. Réseau ad-hoc selon la revendication 1 précédente, **caractérisé en ce que** le au moins un ordinateur (2.1), qui convertit les services Jini, sert de serveur dans le réseau local.

3. Réseau ad-hoc selon la revendication 1 précédente, **caractérisé en ce que** le au moins un ordinateur, qui convertit les services Jini, sert de client du réseau local.

4. Réseau ad-hoc selon la revendication 1 précédente, **caractérisé en ce que** le au moins un ordinateur (6), qui convertit les services Jini, sert de station de base d'un réseau local.

5. Réseau ad-hoc selon l'une quelconque des revendications 1 à 4 précédentes, **caractérisé en ce que** la liaison entre le au moins un ordinateur, qui convertit les services Jini, et le réseau physique est établie sans fil et/ou avec un couplage galvanique.

6. Réseau ad-hoc selon l'une quelconque des revendications 1 à 5 précédentes, **caractérisé en ce que** les attributs dépendant du lieu sont choisis de façon spécifiée au local.

7. Réseau ad-hoc selon l'une quelconque des revendications 1 à 6 précédentes, **caractérisé en ce que**, lors de la présence de plusieurs services (3.x) similaires dans le réseau local, à chaque fois les services les plus proches localement sont offerts en priorité ou exclusivement à chaque appareil (5.x) se trouvant dans un réseau physique (5).

8. Réseau ad-hoc selon l'une quelconque des revendications 1 à 7 précédentes, **caractérisé en ce que** les attributs dépendant du lieu sont définis de façon hiérarchique en fonction de leur possibilité d'utilisation dépendante du lieu.
